# EUROPÄISCHE PATENTANMELDUNG

(11) **EP 3 499 554 A1**
(43) Veröffentlichungstag der Anmeldung: **19.06.2019**
(21) Anmeldenummer: 17207044.3
(22) Anmeldetag: 13.12.2017
(51) Int. Cl.: H01L 21/60, H05K 3/34

(54) **VERFAHREN ZUR HERSTELLUNG EINER SANDWICHANORDNUNG AUS ZWEI BAUELEMENTEN MIT DAZWISCHEN BEFINDLICHEM LOT MITTELS HEISSPRESSENS UNTERHALB DER SCHMELZTEMPERATUR DES LOTMATERIALS EINER LOTVORFORM**

(71) Anmelder: Heraeus Deutschland GmbH & Co. KG, 63450 Hanau (DE)
(72) Erfinder: SCHÄFER, Michael, 36093 Künzell (DE); SCHMITT, Wolfgang, 63110 Rodgau (DE)
(74) Vertreter: Heraeus IP

(57) **Zusammenfassung**

Verfahren zur Herstellung einer festen Sandwichanordnung aus zwei Bauelementen mit dazwischen befindlichem Lot umfasst die Schritte:
(1) Bereitstellen zweier jeweils mindestens eine Kontaktfläche aufweisender Bauelemente und einer freien Lotvorform,
(2) Herstellen einer Sandwichanordnung aus den Bauelementen und einer zwischen diesen angeordneten und damit noch nicht verbundenen Lotvorform durch Inkontaktbringen (i) jeweils einer der Kontaktflächen oder (ii) jeweils der einzigen Kontaktfläche der Bauelemente oder (iii) einer der Kontaktflächen des einen Bauelements und der einzigen Kontaktfläche des anderen Bauelements mit den Kontaktflächen der freien Lotvorform, und
(3) Heißpressen der in Schritt (2) hergestellten Sandwichanordnung unter Bildung der festen Sandwichanordnung bei einer 10 bis 40% unterhalb der in °C ausgedrückten Schmelztemperatur des Lotmetalls der Lotvorform liegenden Temperatur.

Jedes der beiden Bauelemente kann aus der aus Substraten, aktiven Bauelementen und passiven Bauelementen bestehenden Gruppe ausgewählt sein.

Die Kombination von Pressdruck und Pressdauer kann in einem Bereich liegen, welcher eine Reduktion der ursprünglichen Dicke der ursprünglich freien Lotvorform von <10% bewirkt.

Das Verfahren nach die weiteren Schritte umfassen:
(4) Erhitzen der festen Sandwichanordnung auf eine Temperatur oberhalb der Schmelztemperatur des Lotmetalls der die beiden Bauelemente verbindenden Lotverbindung, und
(5) Abkühlen der Sandwichanordnung unter die Erstarrungstemperatur des zwischen den Bauelementen befindlichen geschmolzenen Lotmetalls unter Ausbildung einer Lötverbindung zwischen den Bauelementen.

## Beschreibung

Die Erfindung betrifft ein Verfahren zur Herstellung einer festen Sandwichanordnung aus zwei Bauelementen mit dazwischen befindlichem Lot.

Der hierin verwendete Ausdruck "feste Sandwichanordnung aus zwei Bauelementen mit dazwischen befindlichem Lot", kurz auch als "feste Sandwichanordnung" bezeichnet, bedeutet, dass die beiden Bauelemente, über das dazwischen befindliche Lot vermittelt, mit einer Scherfestigkeit von >0,1 MPa aneinander haften; anders ausgedrückt, sie weisen eine die Haftfestigkeit aneinander beschreibende Scherfestigkeit von >0,1 MPa auf. Die Scherfestigkeit kann mittels eines üblichen Schertesters bestimmt werden.

US 4,659,006 offenbart das Verbinden eines Substrats mit einer freien Lotvorform durch Heißpressen als Teilschritt eines Verfahrens zur Herstellung einer Lötverbindung zwischen einem Halbleiterchip und einem Substrat. Beim Verbinden des Substrats mit der freien Lotvorform werden Substrat und Lotvorform zunächst miteinander in Kontakt gebracht und anschließend gemeinsam auf eine unterhalb der Schmelztemperatur der Lotvorform liegende Temperatur erhitzt. Während der Einwirkung dieser Temperatur wird ein Pressdruck auf die Lotvorform ausgeübt. Dabei wird die ursprüngliche Dicke der Lotvorform um mindestens 40% reduziert. Anschließend wird die so geschaffene Anordnung aus mit Lotdepot ausgestattetem Substrat mit einem Halbleiterchip in üblicher Weise verlötet.

Hierin wird bewusst zwischen einer Lot- und einer Lötverbindung von Bauelementen unterschieden. Während Lotverbindung wie auch Lötverbindung beide eine thermisch leitende, elektrisch leitende und mechanische Verbindung von Bauelementen bewirken, besteht der Unterschied zwischen Lotverbindung und Lötverbindung darin, dass das Lotmetall bei der Bildung einer Lötverbindung anders als bei der Bildung einer Lotverbindung zwischen den Bauelementen geschmolzen und wieder erstarrt wird, mit anderen Worten, über seine Schmelztemperatur hinaus erhitzt und danach unter seine Erstarrungstemperatur abgekühlt wird.

Die Anmelderin konnte nunmehr für sie selber überraschend feststellen, dass die Herstellung einer Lotverbindung zwischen Bauelementen, beispielsweise zwischen einem Halbleiterchip und einem Substrat, durch Heißpressen in einem Prozessschritt gelingt.

Die Erfindung betrifft ein Verfahren zur Herstellung einer festen Sandwichanordnung aus zwei Bauelementen mit dazwischen befindlichem Lot, d.h. die beiden Bauelemente thermisch leitend, elektrisch leitend und mechanisch verbindendem Lot. Das Verfahren umfasst die Schritte:
(1) Bereitstellen zweier jeweils mindestens eine Kontaktfläche aufweisender Bauelemente und einer freien Lotvorform,
(2) Herstellen einer Sandwichanordnung aus den Bauelementen und einer zwischen diesen angeordneten und damit noch nicht verbundenen Lotvorform durch Inkontaktbringen (i) jeweils einer der Kontaktflächen oder (ii) jeweils der einzigen Kontaktfläche der Bauelemente oder (iii) einer der Kontaktflächen des einen Bauelements und der einzigen Kontaktfläche des anderen Bauelements mit den Kontaktflächen der freien Lotvorform, und
(3) Heißpressen der in Schritt (2) hergestellten Sandwichanordnung unter Bildung der festen Sandwichanordnung bei einer 10 bis 40% unterhalb der in °C ausgedrückten Schmelztemperatur des Lotmetalls der Lotvorform liegenden Temperatur.

In Schritt (1) des Verfahrens werden zwei jeweils mindestens eine Kontaktfläche aufweisende Bauelemente und eine freie Lotvorform bereitgestellt.

Im Rahmen der Erfindung soll der Begriff Bauelement vorzugsweise Einzelteile umfassen. Diese Einzelteile sind vorzugsweise nicht weiter zerlegbar.

Die Kontaktfläche(n) von Bauelementen sind im Allgemeinen metallisch, beispielsweise in Form einer Metallisierungsschicht. Das Metall eines Bauelements respektive seiner Kontaktfläche(n) kann reines Metall oder eine Legierung aus >50 bis <100 Gew.-% des Metalls und dementsprechend >0 bis <50 Gew.-% aus mindestens einem anderen Metall sein. Beispiele für das reine Metall respektive das Legierungshauptmetall sind Zinn, Kupfer, Silber, Gold, Nickel, Palladium und Platin, insbesondere Zinn, Kupfer, Silber, Gold, Palladium und Platin.

Die in Schritt (2) bei der Herstellung der Sandwichanordnung genutzten Kontaktflächen der Bauelemente können eine Größe beispielsweise im Bereich von 1 bis 3000 mm², insbesondere >10 bis 1000 mm², speziell 15 bis 500 mm² haben.

Bei einem Bauelement im Sinne der Erfindung kann es sich um ein Substrat oder um ein aktives oder ein passives Bauelement handeln. Insbesondere handelt es sich um ein Bauteil wie es in der Elektronik verwendet wird.

Beispiele für Substrate sind IMS-Substrate (insulated metal-Substrate), DCB-Substrate (direct copper bonded-Substrate), AMB-Substrate (active metal braze-Substrate), keramische Substrate, PCBs (printed circuit boards) und Leadframes.

Beispiele für aktive Bauelemente sind Dioden, LEDs (light emitting diodes, lichtemittierende Dioden), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxide-semiconductor field-effect transistors, Metall-Oxid-Halbleiter-Feldeffekttransistoren).

Beispiele für passive Bauelemente sind Sensoren, Bodenplatten, Kühlkörper, Widerstände, Kondensatoren, Transformatoren, Drosseln und Spulen.

Die beiden in Schritt (1) bereitgestellten Bauelemente können von derselben Art sein, d.h. es kann sich beispielsweise in beiden Fällen um Substrate handeln, oder es handelt sich jeweils um aktive oder passive Bauelemente oder um ein aktives und ein passives Bauelement. Es kann aber auch sein, dass es sich bei dem einen Bauelement um ein Substrat und bei dem anderen Bauelement um ein aktives oder passives Bauelement handelt. Beispielsweise lassen sich so folgende Fälle unterscheiden:

| **Erstes Bauelement:** | **Weiteres Bauelement:** |
|---|---|
| Substrat | Substrat |
| Aktives Bauelement | Passives Bauelement |
| Passives Bauelement | Aktives Bauelement |
| Aktives Bauelement | Aktives Bauelement |
| Passives Bauelement | Passives Bauelement |
| Substrat | Aktives Bauelement |
| Substrat | Passives Bauelement |
| Passives Bauelement | Substrat |
| Aktives Bauelement | Substrat |

Außer den mindestens eine Kontaktfläche aufweisenden Bauelementen wird in Schritt (1) des Verfahrens eine freie, d.h. diskrete Lotvorform bereitgestellt.

Bei einer freien Lotvorform im Sinne der Erfindung handelt es sich insbesondere um Lotmetall in Form eines flachen Formteils, beispielsweise Lotmetallfolie, Lotmetallband oder ein Lotmetallplättchen. Solche freien Lotvorformen haben diskrete Kontaktflächen, d.h. voneinander separate und unterscheidbare Kontaktflächen, insbesondere zwei auf einander gegenüberliegenden Seiten angeordnete Kontaktflächen. Die Form der Kontaktflächen kann beliebig sein, beispielsweise rund, sechseckig, dreieckig, bevorzugt rechteckig. Größe und Form entsprechen bevorzugt der der Kontaktfläche des Bauelements. Die Dicke der freien Lotvorform kann beispielsweise im Bereich von 10 bis 500 µm oder 50 bis 300 µm liegen.

Bei dem Lotmetall (Lot) der Lotvorform handelt es sich im Allgemeinen um Indium, Indiumlegierungen oder insbesondere um Zinn oder zinnreiche Legierungen. Beispiele für zinnreiche Legierungen sind solche mit einem Zinnanteil beispielsweise im Bereich von 90 bis 99,5 Gew.-% (Gewichts-%). Beispiele für Legierungsmetalle sind Kupfer, Silber, Indium, Germanium, Nickel, Blei, Bismut und Antimon. Die Legierungen können bleihaltig oder bleifrei sein. Bleifreie Legierungen können beispielsweise ausgewählt sein aus der Gruppe bestehend aus SnAg, SnBi, SnSb, SnAgCu, SnCu, SnSb, InSnCd, InBiSn, InSn, BiSnAg oder SnAgCuBiSbNi. Bleihaltige Legierungen können beispielsweise ausgewählt sein aus der Gruppe umfassend SnPb und SnPbAg. Die Schmelztemperatur des Lotmetalls kann beispielsweise im Bereich von 140 bis 380°C, insbesondere 170 bis 300°C liegen.

In Schritt (2) des erfindungsgemäßen Verfahrens wird eine Sandwichanordnung aus den Bauelementen und einer zwischen diesen angeordneten und damit noch nicht verbundenen Lotvorform hergestellt, entweder (i) durch Inkontaktbringen jeweils einer der Kontaktflächen der Bauelemente mit den Kontaktflächen der freien Lotvorform oder (ii) durch Inkontaktbringen jeweils der einzigen Kontaktfläche der Bauelemente mit den Kontaktflächen der freien Lotvorform oder (iii) durch Inkontaktbringen einer der Kontaktflächen des einen Bauelements und der einzigen Kontaktfläche des anderen Bauelements mit den Kontaktflächen der freien Lotvorform.

Das Inkontaktbringen kann beispielsweise erfolgen durch Platzieren der freien Lotvorform mit einer ihrer Kontaktflächen zur betreffenden Kontaktfläche des einen Bauelements und mit ihrer anderen Kontaktfläche zur betreffenden Kontaktfläche des anderen Bauelements hingewandt. Im Allgemeinen bedeutet Platzieren der freien Lotvorform ein Auflegen derselben auf das eine Bauelement gefolgt vom Auflegen des noch fehlenden Bauelements auf die Lotvorform. Anstelle des Auflegens kann es sich auch um ein Bestücken handeln.

In einer Ausführungsform kann ein Fixiermittel aus einer Fixiermittelzusammensetzung zwischen den jeweiligen miteinander in Kontakt zu bringenden Kontaktflächen verwendet werden respektive auf eine oder beide der jeweiligen Kontaktflächen vor dem miteinander Inkontaktbringen appliziert werden.

In Schritt (3) des erfindungsgemäßen Verfahrens wird die in Schritt (2) hergestellte Sandwichanordnung einer Heißpressung unterworfen, bei der sich Bauelemente und Lotvorform zu einer festen Sandwichanordnung verbinden. Dabei bildet sich eine Lotverbindung zwischen den Bauelementen aus.

Als Arbeitsgerät kann beispielsweise eine übliche Heißpresse verwendet werden.

Das Heißpressen findet statt bei einer 10 bis 40% unterhalb der in °C ausgedrückten Schmelztemperatur des Lotmetalls der Lotvorform liegenden Temperatur. Beispielsweise kann die Schmelztemperatur des Lotmetalls konkret im Bereich von 140 bis 380 °C liegen und die Temperatur dann während des Heißpressens beispielsweise im Bereich von 84 bis 342 °C.

In einer bevorzugten Ausführungsform des erfindungsgemäßen Verfahrens kann die während des Heißpressens wirkende Kombination von Pressdruck und Pressdauer in einem Bereich liegen, welcher eine Reduktion der ursprünglichen Dicke der ursprünglich freien Lotvorform (d.h. der Lotvorform in ihrem ursprünglich freien Zustand) von ≤10% bewirkt. Abhängig von der ursprünglichen Dicke der in Schritt (1) bereitgestellten ursprünglich freien Lotvorform kann besagte bei ≤10% liegende Dickenreduktion beispielsweise im Bereich von 0 bis 50 µm liegen.

Die Kombination von Pressdruck und Pressdauer, welche bei einer 10 bis 40% unterhalb der in °C ausgedrückten Schmelztemperatur des Lotmetalls der Lotvorform liegenden Temperatur eine Reduktion der ursprünglichen Dicke der ursprünglich freien Lotvorform von ≤10% bewirkt, kann beispielsweise im Bereich von 10 bis 200 MPa Pressdruck und 1 Sekunde bis 5 Minuten Pressdauer liegen. Je höher der gewählte Pressdruck, desto kürzer kann die Pressdauer gewählt werden und umgekehrt.

Das erfindungsgemäße Verfahren arbeitet mit bedeutend milderen als den in eingangs erwähnter US 4,659,006 offenbarten Heißpressbedingungen. In Form der erfindungsgemäß gebildeten festen Sandwichanordnung erzielt es dabei eine hinreichend feste Verbindung von Bauelementen und ursprünglich freier Lotvorform.

Wie vorerwähnt hat das erfindungsgemäße Verfahren diverse Vorteile, sowohl mit Blick auf die eigentliche Verfahrensdurchführung als auch hinsichtlich des direkten Verfahrensprodukts in Form der festen Sandwichanordnung aus den beiden Bauelementen mit dazwischen befindlichem Lot.

Das erfindungsgemäße Verfahren kann mit einer vergleichsweise einfach gebauten Heißpresse durchgeführt werden.

Das erfindungsgemäße Verfahren kann auch mit druckempfindlicheren als den in eingangs erwähnter US 4,659,006 offenbarten Bauelementen durchgeführt werden.

In Ausführungsformen kann das erfindungsgemäße Verfahren respektive das Heißpressen sogar, ohne besondere Vorkehrungen zu treffen, in normaler Umgebungsatmosphäre, also an der Luft durchgeführt werden, d.h. es ist weder erforderlich unter Inertgas noch in reduzierender Atmosphäre wie beispielsweise einer Inertgas/Wasserstoff-Atmosphäre zu arbeiten.

Die nach Abschluss des erfindungsgemäßen Verfahrens gemäß der bevorzugten Ausführungsform die Bauelemente verbindende ehemalige Lotvorform (d.h. die gemäß der bevorzugten Ausführungsform des erfindungsgemäßen Verfahrens hergestellte Lotverbindung) zeichnet sich nicht nur durch eine ≤10% gegenüber der ursprünglichen Dicke der ursprünglich freien Lotvorform verringerte Dicke aus, sondern auch durch nach Beendigung des Heißpressens im Wesentlichen gegenüber dem Ursprung unveränderte Form und Flächenmaß. So treten im Wesentlichen keine Ausbuchtungen an den Außenrändern des die Bauelemente verbindenden Lots auf, eine vorteilhafte Tatsache im Hinblick auf eine fortschreitende Miniaturisierung im Elektronikbereich und der damit einhergehenden Erhöhung der Bauelementdichte. Beispielsweise bleiben ursprünglich rechteckige freie Lotvorformen auch in mit den Bauelementen verbundener Form im Wesentlichen rechteckig mit im Wesentlichen geraden, d.h. im Wesentlichen nicht gebogenen Außenrändern. Der in diesem Absatz mehrfach verwendete Ausdruck "im Wesentlichen" bezieht sich auf eine Betrachtung mit dem bloßen Auge.

Nach Abschluss von Schritt (3) erhält man eine feste Sandwichanordnung aus den beiden in Schritt (1) bereitgestellten Bauelementen mit dazwischen befindlichem die beiden Bauelemente thermisch leitend, elektrisch leitend und mechanisch verbindendem Lot. Bei diesem Lot handelt es sich um eine Lotverbindung.

Die feste Sandwichanordnung hat eine mindestens Transportfähigkeit (beispielsweise auf dem Weg zum weiteren Handling) gewährleistende Festigkeit oder sogar eine höhere, ein anschließendes Löten (Nachlöten) nicht erfordernde Festigkeit. Insofern kann es zweckmäßig oder notwendig oder auch einfach nur gewünscht sein, nach Beendigung von Schritt (3) einen klassischen Lötvorgang anzuschließen. Beim dem Fachmann an sich bekannten und daher keiner näheren Erläuterung bedürfenden klassischen Löten schließen sich ans erfindungsgemäße Verfahren folgende Schritte an:
(4) Erhitzen der festen Sandwichanordnung auf eine Temperatur oberhalb der Schmelztemperatur des Lotmetalls der die beiden Bauelemente verbindenden Lotverbindung, und
(5) Abkühlen der Sandwichanordnung unter die Erstarrungstemperatur des zwischen den Bauelementen befindlichen geschmolzenen Lotmetalls unter Ausbildung einer Lötverbindung zwischen den Bauelementen.

Bei Schritt (4) handelt es sich um ein Verlöten.

Nach Abschluss von Schritt (5) erhält man eine feste Sandwichanordnung aus den beiden in Schritt (1) bereitgestellten Bauelementen mit dazwischen befindlichem die beiden Bauelemente thermisch leitend, elektrisch leitend und mechanisch verbindendem Lot. Bei diesem Lot handelt es sich um eine Lötverbindung.

### Erfindungsgemäßes Beispiel 1

Auf die Kupferoberfläche eines DCB-Substrats (Aluminiumoxid-Keramik, 25 mm x 25 mm x 380 µm, beidseitig auf den quadratischen Flächen ausgestattet mit 300 µm Kupfer) wurden mittig eine Lotvorform (Sn3,5Ag; Schmelztemperatur 221 °C; 9 mm x 9 mm x 0,20 mm) und darauf passgenau ein Si-Chip (SKCD 81 C 060 I3) aufgelegt und die so geschaffene Sandwichanordnung zwischen die beiden auf 150°C vorgeheizten Platten einer Heißpresse (Sinterstar Innovate F-XL der Fa. Boschmann) verbracht. Für einen Zeitraum von 60 Sekunden wurde ein Pressdruck von 100 MPa auf die Probe ausgeübt.

Mittels einer MITUTOYO ABSOLUTE Digimatic Messuhr wurde die Dickenreduktion der ehemaligen Lotvorform ermittelt.

Die Scherfestigkeit der Probe wurde mittels eines DAGE 4000 plus Schertesters der Fa. Nordson bei einer Geschwindigkeit von 0,3 mm/s bei 20°C gemessen.

Analog zu Beispiel 1 wurden Beispiele 2 bis 14 durchgeführt.

Nachfolgende Tabelle zeigt die Einflüsse von Presstemperatur, Pressdauer bzw. Pressdruck während des Heißpressens.

| Beispiel | Presstemperatur (°C) | Pressdruck (MPa) | Pressdauer (s) | Dickenreduktion (µm) | Transportfähigkeit (Scherfestigkeit >0,1 MPa) | Nachlöten erforderlich (Scherfestigkeit <10 MPa) |
|---|---|---|---|---|---|---|
| 1 (erf.) | 150 | 100 | 60 | 1 | ja | ja |
| 2 (erf.) | 150 | 100 | 120 | 2 | ja | nein |
| 3 (erf.) | 150 | 100 | 300 | 5 | ja | nein |
| 4 (erf.) | 190 | 100 | 60 | 2 | ja | nein |
| 5 (erf.) | 190 | 100 | 120 | 8 | ja | nein |
| 6 (erf.) | 190 | 100 | 300 | 22 | ja | nein |
| 7 (erf.) | 150 | 50 | 120 | 0 | ja | ja |
| 8 (nicht erf.) | 150 | 50 | 60 | 0 | nein | - |
| 9 (nicht erf.) | 150 | 50 | 10 | 0 | nein | - |
| 10 (erf.) | 150 | 50 | 300 | 2 | ja | nein |
| 11 (erf.) | 190 | 50 | 120 | 5 | ja | nein |
| 12 (erf.) | 190 | 50 | 60 | 1 | ja | nein |
| 13 (nicht erf.) | 190 | 50 | 10 | 0 | nein | - |
| 14 (erf.) | 190 | 50 | 300 | 6 | ja | nein |

## Patentansprüche

1. Verfahren zur Herstellung einer festen Sandwichanordnung aus zwei Bauelementen mit dazwischen befindlichem Lot umfassend die Schritte:
(1) Bereitstellen zweier jeweils mindestens eine Kontaktfläche aufweisender Bauelemente und einer freien Lotvorform,
(2) Herstellen einer Sandwichanordnung aus den Bauelementen und einer zwischen diesen angeordneten und damit noch nicht verbundenen Lotvorform durch Inkontaktbringen (i) jeweils einer der Kontaktflächen oder (ii) jeweils der einzigen Kontaktfläche der Bauelemente oder (iii) einer der Kontaktflächen des einen Bauelements und der einzigen Kontaktfläche des anderen Bauelements mit den Kontaktflächen der freien Lotvorform, und
(3) Heißpressen der in Schritt (2) hergestellten Sandwichanordnung unter Bildung der festen Sandwichanordnung bei einer 10 bis 40% unterhalb der in °C ausgedrückten Schmelztemperatur des Lotmetalls der Lotvorform liegenden Temperatur.

2. Verfahren nach Anspruch 1, wobei jedes der beiden Bauelemente ausgewählt ist aus der aus Substraten, aktiven Bauelementen und passiven Bauelementen bestehenden Gruppe.

3. Verfahren nach Anspruch1 oder 2, wobei es sich bei der freien Lotvorform um Lotmetallfolie, Lotmetallband oder ein Lotmetallplättchen handelt.

4. Verfahren nach einem der vorhergehenden Ansprüche, wobei die freie Lotvorform 10 bis 500 µm dick ist.

5. Verfahren nach einem der vorhergehenden Ansprüche, wobei die Schmelztemperatur des Lotmetalls der freien Lotvorform im Bereich von 140 bis 380°C liegt.

6. Verfahren nach einem der vorhergehenden Ansprüche, wobei die Schmelztemperatur des Lotmetalls der freien Lotvorform im Bereich von 140 bis 380 °C und die Temperatur während des Heißpressens im Bereich von 84 bis 342 °C liegt.

7. Verfahren nach einem der vorhergehenden Ansprüche, wobei die Kombination von Pressdruck und Pressdauer in einem Bereich liegt, welcher eine Reduktion der ursprünglichen Dicke der ursprünglich freien Lotvorform von ≤10% bewirkt.

8. Verfahren nach Anspruch 7, wobei der Pressdruck im Bereich von 10 bis 200 MPa und die Pressdauer im Bereich von 1 Sekunde bis 5 Minuten liegt.

9. Verfahren nach einem der vorhergehenden Ansprüche umfassend die weiteren Schritte:
(4) Erhitzen der festen Sandwichanordnung auf eine Temperatur oberhalb der Schmelztemperatur des Lotmetalls der die beiden Bauelemente verbindenden Lotverbindung, und
(5) Abkühlen der Sandwichanordnung unter die Erstarrungstemperatur des zwischen den Bauelementen befindlichen geschmolzenen Lotmetalls unter Ausbildung einer Lötverbindung zwischen den Bauelementen.
